# FASCICULE DE BREVET EUROPEEN

(11) **EP 3 523 867 B1**
(45) Date de publication et mention de la délivrance du brevet: **01.11.2023**
(21) Numéro de dépôt: 17808137.8
(22) Date de dépôt: 05.10.2017
(51) Int. Cl.: H02J 7/00, B60L 3/00, G05F 1/573, H03K 17/082

(54) **CIRCUIT DE DECHARGE D'UN SYSTÈME ELECTRIQUE HAUTE TENSION**
SCHALTUNG ZUM ENTLADEN EINES ELEKTRISCHEN HOCHSPANNUNGSSYSTEMS
CIRCUIT FOR DISCHARGING A HIGH-VOLTAGE ELECTRICAL SYSTEM

(30) Priorité: 06.10.2016 FR 1659635
(43) Date de publication de la demande: 14.08.2019
(73) Titulaire: Valeo Japan Co., Ltd., Saitama 360-0193 (JP)
(72) Inventeur: BERTRAND, Mathieu, 95800 Cergy Le Haut (FR); SACCO, Ernesto, 95000 Cergy Pontoise (FR); NAIM, Aldo, 27930 Sacquenville (FR)
(74) Mandataire: Valeo Systèmes Thermiques
(86) Numéro de dépôt international: PCT/IB2017/056138
(87) Numéro de publication internationale: WO 2018/065927

(56) Documents cités:
- EP-A1- 2 495 875
- EP-A1- 2 894 057
- US-A1- 2013 207 458

## Description

### Domaine technique

La présente invention concerne un circuit de décharge d'un système électrique haute tension, tel que notamment une unité de contrôle d'un moteur de véhicule hybride ou électrique.

### État de la technique antérieure

Dans des systèmes électriques haute tension, tels que par exemple des convertisseurs AC-DC, des chargeurs ou encore des modules de puissance pour des moteurs électriques ou hybrides, il est très important d'isoler les conducteurs électriques de puissance afin de protéger les utilisateurs des dispositifs dans lesquels ces systèmes électriques sont installés.

Plus particulièrement, dans le domaine automobile, les véhicules électriques et hybrides mettent en oeuvre au moins un moteur électrique triphasé pour générer alternativement un couple moteur sur l'arbre de transmission ou une puissance électrique à partir du couple mécanique disponible sur l'arbre de transmission. Un tel moteur électrique prend place dans un système électrique haute tension complexe qui comprend notamment, outre le moteur électrique, un dispositif de stockage de l'énergie électrique et une unité de contrôle permettant de mettre en forme les signaux de puissance pour le moteur électrique. Tous les composants du système électrique haute tensions sont reliés par un circuit électrique comprenant des conducteurs électriques agencés pour transporter des signaux électriques basse tension et/ou haute tension. En fonctionnement normal, et sans altération de l'intégrité physique du système électrique haute tension, les circuits électriques sont isolés les uns des autres, et notamment de la masse mécanique du véhicule, afin de garantir la sécurité des utilisateurs. En revanche, suite à un accident par exemple, le circuit électrique du système électrique haute tension peut être ouvert suite à la rupture d'un conducteur électrique. Dans certains cas, des conducteurs électriques rompus peuvent être portés au contact de pièces mécaniques du véhicule, portant ces dernières à un potentiel électrique qui peut être dangereux si elles sont touchées. Dans de tels cas, la sécurité physique des utilisateurs ou des personnes intervenant sur le véhicule accidenté peut être mise en danger.

Il existe donc un besoin pour des circuits de décharge permettant de décharger le dispositif de stockage de l'énergie électrique afin de réduire les risques d'électrocution.

On connaît des circuits de décharge passifs qui sont configurés pour décharger le dispositif de stockage de l'énergie électrique de manière automatique et selon toute circonstance, sans intervention et/ou programmation du véhicule. Les circuits de décharge passifs mettent généralement en oeuvre au moins une résistance de dissipation en parallèle du dispositif de stockage de l'énergie électrique. L'inconvénient des circuits de décharge passifs est qu'ils nécessitent une résistance de dissipation de très forte impédance, dont les dimensions importantes rendent sont intégration complexe voire impossible dans certains systèmes électriques. Par ailleurs, le prix d'une résistance de forte impédance est élevé et augmente le coût des circuits de décharge. Un autre inconvénient est une durée de décharge trop longue, typiquement de l'ordre de plusieurs minutes selon le dispositif de stockage de l'énergie électrique et la valeur d'impédance de la résistance de dissipation.

On connaît aussi des circuits de décharge actifs qui permettent de décharger le dispositif de stockage de l'énergie électrique par l'envoi d'une commande permettant de configurer le système électrique haute tension dans une configuration de dissipation. L'inconvénient des circuits de décharge actifs est qu'ils n'opèrent qu'en réponse à une instruction envoyée par une unité de centrale en fonction de paramètres « environnementaux ». Si l'instruction ne parvient pas au circuit de décharge actif, alors ce dernier demeure inopérant et le dispositif de stockage de l'énergie électrique n'est pas déchargé.

Des circuit de décharge d'un système électrique haute tension sont connus notamment des documents EP2894057 et EP2495875.

La présente invention a pour objet de répondre au moins en grande partie aux problèmes précédents et de conduire en outre à d'autres avantages.

Un autre but de l'invention est de proposer un circuit de décharge autonome pour résoudre au moins un de ces problèmes.

Un autre but de la présente invention est de réduire les coûts de fabrication d'un tel circuit de décharge.

Un autre but de l'invention est d'améliorer la sécurité des utilisateurs de véhicules électriques ou, d'une manière plus générale, la sécurité des utilisateurs de systèmes électriques haute tension.

### Exposé de l'invention

Selon un premier aspect de l'invention, on atteint au moins l'un des objectifs précités avec un circuit de décharge d'un système électrique haute tension selon les caractéristiques de la revendication 1.

Grâce au circuit de décharge conforme au premier aspect de l'invention, il est possible d'améliorer la sécurité des utilisateurs de véhicules électriques car le circuit de décharge permet de vider un dispositif de stockage de l'énergie électrique - formé d'un ou plusieurs condensateurs - dans une branche de dissipation - comprenant au moins un des transistors de puissance du système électrique haute tension - en un temps réduit. La branche de régulation contrôle le courant de grille de manière à contrôler la puissance dissipée par le ou les transistors de puissance. Plus particulièrement, le courant de grille est régulé de manière à ce que la puissance dissipée par le transistor de puissance soit suffisamment élevée pour décharger l'au moins un condensateur en un temps de décharge limité d'une part, et d'autre part de manière à ce que à ce que la puissance dissipée ne soit pas trop élevée pour ne pas endommager le ou les transistors de puissance. Typiquement, une puissance de 5W représente un bon compromis pour simultanément restreindre le temps de décharge et protéger le transistor de puissance.

L'invention conforme à son premier aspect propose un circuit de décharge qui met en oeuvre certain des composants électroniques de puissance du système électrique haute tension pour décharger le dispositif de stockage de l'énergie électrique. La décharge du ou des condensateurs du dispositif de stockage de l'énergie électrique est réalisée au moins en partie par dissipation thermique. Ainsi, le circuit de décharge conforme au premier aspect de l'invention permet de ne plus utiliser de résistances de dissipation à fortes impédances comme dans l'art antérieur ; au contraire, le circuit de décharge exploite un des transistors de puissance du système électrique haute tension auquel il est raccordé, permettant de réduire les coûts de fabrication du circuit de décharge. Consécutivement, le circuit de décharge conforme au premier aspect de l'invention permet aussi de gagner de l'espace à l'intérieur d'un module de puissance puisqu'il n'est plus nécessaire d'utiliser de résistances de dissipation.

Selon un deuxième aspect de l'invention, il est proposé d'utiliser un circuit de décharge conforme au premier aspect de l'invention ou à l'un quelconque de ses perfectionnements pour décharger un convertisseur DC/DC, ou un chargeur électrique, ou un compresseur électrique de véhicule automobile, selon les revendications 9 et 10.

Selon un troisième aspect de l'invention, il est proposé une unité de contrôle d'une machine électrique de puissance telle qu'un moteur électrique selon la revendication 11. Les modes de réalisation préférés sont définis dans les revendications dépendantes. L'invention est définie dans les revendications annexées.

Des modes de réalisation variés de l'invention sont prévus, intégrant selon l'ensemble de leurs combinaisons possibles les différentes caractéristiques optionnelles exposées ici.

### Description des figures et des modes de réalisation

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
- la FIGURE 1 illustre de manière schématique un système électrique haute tension comprenant un circuit de décharge conforme au premier aspect de l'invention ;
- la FIGURE 2 illustre une vue simplifiée du circuit de décharge conforme au premier aspect de l'invention ;
- la FIGURE 3 illustre un mode de réalisation particulier d'un circuit de décharge conforme au premier aspect de l'invention.

Bien entendu, les caractéristiques, les variantes et les différentes formes de réalisation de l'invention peuvent être associées les unes avec les autres, selon diverses combinaisons, dans la mesure où elles ne sont pas incompatibles ou exclusives les unes des autres. On pourra notamment imaginer des variantes de l'invention ne comprenant qu'une sélection de caractéristiques décrites par la suite de manière isolées des autres caractéristiques décrites, si cette sélection de caractéristiques est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

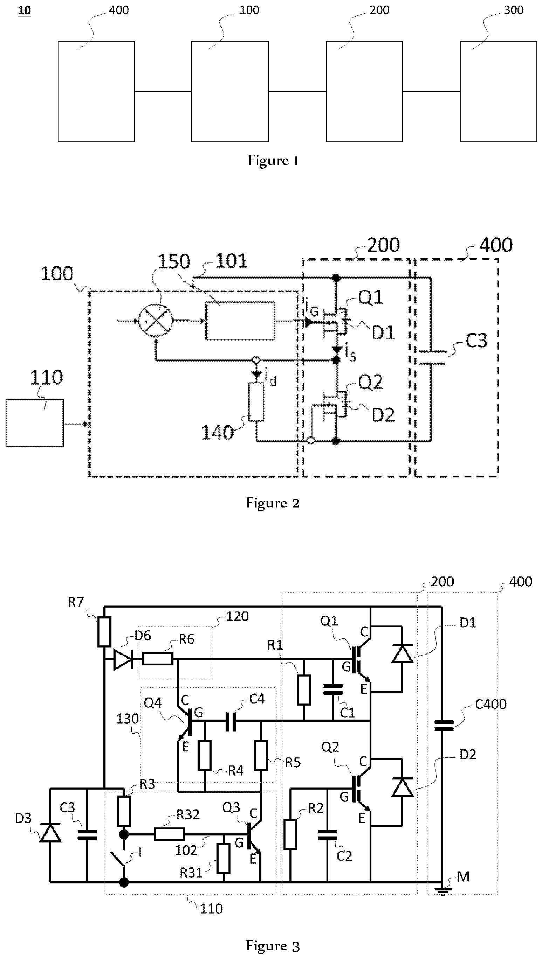

En référence à la FIGURE 1, un système électrique haute tension 10 est illustré. Le système électrique haute tension 10 comprend une machine électrique 300 monophasée ou multiphasée, de préférence triphasée. Plus particulièrement, la machine électrique 300 est du type d'une machine électrique triphasée synchrone à aimant permanent. À titre d'exemple non limitatif, la machine électrique 300 peut être une machine électrique réversible agencée pour fonctionner alternativement comme un moteur électrique générant un couple moteur sur un arbre de transmission d'un véhicule automobile ou comme un générateur électrique afin de convertir un couple mécanique de l'arbre de transmission en électricité.

Le système électrique haute tension 10 comprend un dispositif de stockage de l'énergie électrique 400 connecté électriquement au module d'électronique de puissance 200, le dispositif de stockage de l'énergie électrique 400 est agencé pour stocker de l'électricité. Plus particulièrement, le dispositif de stockage de l'énergie électrique 400 est agencé pour stocker une grande quantité d'énergie d'une part, et pour restituer l'énergie électrique stockée sous certaines conditions du système électrique haute tension 10. À titre d'exemple non limitatif, le dispositif de stockage de l'énergie électrique 400 peut être du type d'au moins une batterie, par exemple du type lithium-ion.

Le système électrique haute tension 10 comprend aussi un module d'électronique de puissance 200 qui est connecté électriquement à la machine électrique 300 d'une part et au dispositif de stockage d'énergie électrique 400 d'autre part. Le module d'électronique de puissance 200 est agencé notamment pour mettre en forme un signal électrique entrant afin de piloter la machine électrique 300. À titre d'exemple non limitatif, le module d'électronique de puissance 200 peut comprendre une pluralité de transistors de puissance pour amplifier le signal électrique entrant provenant par exemple du dispositif de stockage de l'énergie électrique 400 en un signal électrique haute tension permettant d'alimenter et de commander le fonctionnement de la machine électrique 300. À titre d'exemple non limitatif, le signal électrique haute tension est compris entre 200 V et 600 V ; il est préférentiellement égal à 300 V.

Le système électrique haute tension 10 schématisé sur la FIGURE 1 comprend enfin un circuit de décharge conforme au premier aspect de l'invention. Le circuit de décharge 100 est situé entre le module d'électronique de puissance 200 et le dispositif de stockage d'énergie électrique 400. Le circuit de décharge 100 est connecté électriquement avec le module d'électronique de puissance 200 et le dispositif de stockage d'énergie électrique 400. Le circuit de décharge 100 sera décrit plus en détail dans les FIGURES 2 et 3.

La FIGURE 2 illustre un schéma simplifié et fonctionnel du circuit de décharge 100 conforme au premier aspect de l'invention.

Le dispositif de stockage d'énergie électrique 400 est symbolisé par un condensateur 400 dont une première borne est reliée à la masse M du système électrique haute tension 10 et une deuxième borne forme un point de potentiel électrique haut du système électrique haute tension 10.

Le module d'électronique de puissance 200 comprend un premier transistor de puissance Q1 et un deuxième transistor de puissance Q2 monté en série du premier transistor de puissance Q1. Plus particulièrement, une borne émettrice du premier transistor de puissance Q1 est lié à une borne collectrice du deuxième transistor de puissance Q2. Le premier Q1 et le deuxième Q2 transistors de puissance sont collectivement montés en dérivation du condensateur 400.

Une première diode D1 et une deuxième diode D2 sont respectivement montées en dérivation du premier Q1 et deuxième Q2 transistor de puissance, et plus particulièrement entre leur borne collectrice et émettrice. Les diodes D1 et D2 forment chacune une diode dite « de roue libre » afin de protéger respectivement les premier Q1 et deuxième Q2 transistor de puissance.

Préférentiellement, le premier et le deuxième transistors de puissance Q1, Q2 sont chacun du type d'un transistor à grille isolée.

D'une manière générale, le circuit de décharge 100 conforme au premier aspect de l'invention est monté en dérivation du module d'électronique de puissance 200. Ainsi, au moins une partie du module d'électronique de puissance est utilisé par le circuit de décharge 100 comme branche de dissipation afin de décharger l'énergie électrique stockée dans le dispositif de stockage de l'énergie électrique 400.

Le circuit de décharge 100 comprend une branche de pilotage 120 pour configurer au moins un transistor de puissance Q1 du module d'électronique de puissance 200 dans un mode de conduction afin de décharger le condensateur 400, une branche de régulation 130 pour contrôler un courant de grille entrant dans la branche de pilotage 120 du transistor de puissance Q1 de manière à ce que le transistor de puissance Q1 dissipe une puissance inférieure ou égale à 5W pendant une durée de décharge inférieure ou égale à un seuil permettant de décharger complètement le dispositif de stockage de l'énergie électrique 400, ou à le décharger de manière à ce que l'énergie électrique stockée dans le dispositif de stockage de l'énergie électrique ne soit pas dangereuse pour l'homme.

Préférentiellement, la durée de décharge du dispositif de stockage de l'énergie électrique 400 par le circuit de décharge 100 est inférieure ou égale à cinq secondes.

En entrée, le circuit de décharge est électriquement relié à la borne de haut potentiel électrique 101 du dispositif de stockage de l'énergie électrique 400.

Une branche de commutation 110 est configurée pour configurer le circuit de décharge 100 dans une configuration active ou inactive. De manière préférentielle, la branche de commutation 110 est agencée pour configurer le circuit de décharge 100 dans l'une ou l'autre des configurations de manière automatique et autonome en fonction de certains paramètres environnementaux du système électrique 10 et/ou du dispositif sur lequel il est mis en oeuvre, tel que par exemple un véhicule automobile. Avantageusement, la branche de commutation 110 est commandée par un signal électrique du type « interlock » tel que décrit précédemment.

En sortie, le circuit de décharge 100 est agencé pour délivrer dans la borne grille du premier transistor de puissance Q1 un courant de grille i_{g} mis en forme selon une certaine morphologie, en fonction des besoins.

Selon une première variante de réalisation, le circuit de décharge 100 est agencé pour mettre en forme un courant de grille i_{g} invariablement constant, de manière à ce que la puissance dissipée par le module d'électronique de puissance 200 soit constante lorsque le circuit de décharge 100 est actif.

Selon une deuxième variante de réalisation, le circuit de décharge 100 est agencé pour mettre en forme un courant de grille i_{g} qui suit une loi de variation temporelle du type linéaire, de manière à ce que la puissance dissipée par le module d'électronique de puissance 200 varie linéairement lorsque le circuit de décharge 100 est actif.

Bien sûr, la morphologie du courant de grille mis en forme par le circuit de décharge conforme au premier aspect de l'invention n'est pas limité aux exemples évoqués ci-dessus ; le circuit de décharge 100 conforme au premier aspect de l'invention est agencé pour mettre en forme un courant de grille de n'importe quelle morphologie en fonction des besoins des utilisateurs. Il est aussi possible par exemple de mettre en forme un courant de grille suivant une loi de décroissance ou de croissance exponentielle afin de dissiper dans le module d'électronique de puissance 200 une puissance électrique plus importante respectivement en début de décharge ou en fin de décharge.

Pour ce faire, le circuit de décharge 100 met en oeuvre une branche de régulation 130 qui sera détaillée en référence à la FIGURE 3. La branche de régulation 130 comprend un détecteur de courant 140 monté en dérivation du deuxième transistor de puissance Q2, entre la borne émettrice du premier transistor de puissance Q1 et la masse M du système électrique haute tension 10. Le détecteur de courant 140 est agencé pour détecter un courant détecté i_{d} formé à partir d'un courant de sortie iₛ du premier transistor de puissance Q1, et plus particulièrement pour dériver une partie du courant de sortie iₛ vers la masse M du système électrique haute tension 10.

La partie du courant de sortie iₛ qui n'est pas dérivée vers la masse M du système électrique haute tension 10 est orientée vers un comparateur 150 agencé pour mettre en forme le courant de grille i_{g} entrant dans le premier transistor de puissance Q1 par sa borne grille.

Ainsi, le courant de grille ig entrant dans le premier transistor de puissance Q1 est défini à la fois en fonction du courant dérivé id et du courant de sortie is du premier transistor de puissance Q1. D'une manière générale, si le courant de sortie iₛ augmente, alors le courant dérivé i_{d} augmente et le courant de grille i_{g} diminue, conduisant à une réduction du courant de sortie iₛ. A contrario, si le courant de sortie iₛ diminue, alors le courant dérivé i_{d} diminue et le courant de grille i_{g} augmente, conduisant à une augmentation du courant de sortie iₛ.

En fonction du type de composants électroniques formant la branche de régulation 130, et plus particulièrement ceux formant le détecteur de courant 140 et le comparateur 150, il est possible de mettre en forme une grande variété de courant de grille i_{g} selon les applications recherchées et les besoins.

La FIGURE 3 illustre un mode de réalisation particulier d'un circuit de décharge 100 conforme au premier aspect de l'invention.

Le dispositif de stockage d'énergie électrique 400 est ici symbolisé par un condensateur 400 dont une première borne est reliée à la masse M du système électrique haute tension 10 et une deuxième borne forme un point de potentiel électrique haut du système électrique haute tension 10.

Le module d'électronique de puissance 200 comprend un premier transistor de puissance Q1 et un deuxième transistor de puissance Q2 monté en série du premier transistor de puissance Q1, tel que décrit en référence à la FIGURE 2. Le premier Q1 et le deuxième Q2 transistors de puissance sont collectivement montés en dérivation du condensateur 400.

Chaque transistor de puissance Q1, Q2 comprend une diode de roue libre D1, D2 telle que décrite en référence à la FIGURE 2.

Chaque transistor de puissance Q1, Q2 comprend un étage de polarisation formé par au moins une résistance de polarisation R1, R2 et un condensateur C1, C2 de filtrage. Chaque résistance de polarisation R1, R2 et chaque condensateur de filtrage C1, C2 sont montés en dérivation du transistor de puissance correspondant Q1, Q2, et plus particulièrement entre sa borne de grille G et sa borne émettrice E. Chaque étage de polarisation permet de définir un point de fonctionnement à partir duquel le transistor de puissance correspondant Q1, Q2 est configuré dans un mode de conduction dans lequel le courant entrant à sa borne grille est amplifié et ressort par sa borne émettrice. Pour un état de polarisation électrique inférieur au point de fonctionnement défini par l'étage de polarisation, le transistor de puissance est bloqué et se comporte comme un interrupteur ouvert.

Le circuit de décharge 100 comprend une branche de régulation 130 montée en dérivation de la borne émettrice du premier transistor de puissance Q1. La branche de régulation 130 comprend un transistor de régulation Q4 monté en dérivation de la borne émettrice du premier transistor de puissance Q1. Plus particulièrement, une borne grille G du transistor de régulation Q4 est reliée à la borne émettrice E du premier transistor de puissance Q1 par l'intermédiaire d'une capacité de filtrage C4, et une borne collectrice C du transistor de régulation Q4 est reliée à la borne grille G du premier transistor de puissance Q1.

Une résistance de polarisation R4 est montée en dérivation entre la borne grille G et la borne émettrice E du transistor de régulation Q4.

De manière comparable aux étages de polarisation des transistors de puissance Q1, Q2, la résistance de polarisation R4 et la capacité de filtrage C4 forment collectivement un étage de polarisation pour le transistor de régulation Q4.

La branche de régulation 130 comprend aussi un détecteur de courant 140 prenant la forme d'une résistance de décharge R5 montée en dérivation entre la borne grille G et la borne émettrice E du transistor de régulation Q4.

Ainsi, selon le mode de réalisation illustré sur la FIGURE 3, le premier transistor de puissance Q1 est contrôlé par la branche de régulation 130 afin de dissiper une puissance électrique qui était stockée par le condensateur 400 et qui est déchargée sous la forme d'un courant de grille i_{g}. Le courant de grille i_{g} est régulé par la branche de régulation 130, par l'intermédiaire de la résistance de décharge R5 et le transistor de régulation Q4 : lorsque le courant de sortie iₛ du premier transistor de puissance Q1 augmente, alors le courant dérivé i_{d} traversant la résistance de décharge R5 augmente. Le courant entrant dans le transistor de régulation Q4 augmente, entraînant une dérivation plus importante du courant de la branche de pilotage 120 vers sa borne collectrice C. Cette dérivation plus importante entraîne une diminution du courant sortant de la branche de pilotage 120 et, *in fine,* une diminution du courant de grille i_{g} entrant dans le premier transistor de puissance Q1. A contrario, lorsque le courant de sortie iₛ du premier transistor de puissance Q1 diminue, alors le courant dérivé i_{d} traversant la résistance de décharge R5 diminue. Le courant entrant dans le transistor de régulation Q4 diminue, entraînant une dérivation moins importante du courant sortant de la branche de pilotage 120 et, *in fine,* une augmentation du courant de grille i_{g} entrant dans le premier transistor de puissance Q1.

Ainsi, le premier transistor de puissance Q1 est piloté par le circuit de décharge 100 pour dissiper une puissance électrique en fonction du courant de grille i_{g} mis en forme par la branche de régulation120. Préférentiellement, le deuxième transistor de puissance Q2 n'est pas utilisé pour dissiper la puissance électrique, il n'est pas régulé par la branche de régulation 130. Alternativement, la branche de régulation pourrait contrôler une pluralité de transistors de puissance Q1, Q2 du module de puissance 200, ou le circuit de décharge 100 pourrait comprendre une pluralité de branche de régulation 130 contrôlant chacune un transistor de puissance Q1, Q2 du module d'électronique de puissance 200.

Le circuit de décharge 100 comprend aussi une branche de commutation 110 agencée pour prendre au moins deux positions : une première position dans laquelle le circuit de décharge 100 est inactif, le condensateur 400 n'étant pas déchargé, et une deuxième position dans laquelle le circuit de décharge 100 est actif, le condensateur 400 étant déchargé au travers du premier transistor de puissance Q1.

Plus particulièrement, la branche de commutation 110 comprend (i) un transistor de commutation Q3 monté en série entre la branche de régulation et la masse M du système électrique haute tension 10 via respectivement sa borne collectrice C et sa borne émettrice E, et (ii) un interrupteur I monté en dérivation du transistor de commutation Q3, et plus précisément entre la borne grille G et la borne émettrice E du transistor de commutation Q3.

Le transistor de commutation Q3 est polarisé par une branche de polarisation qui permet de définir un point de fonctionnement à partir duquel le transistor de commutation Q3 est configuré dans un mode de conduction dans lequel le courant entrant à sa borne grille est amplifié et ressort par sa borne émettrice. Pour un état de polarisation électrique inférieur au point de fonctionnement défini par l'étage de polarisation, le transistor de commutation Q3 est bloqué et se comporte comme un interrupteur ouvert.

La branche de polarisation du transistor de commutation Q3 comprend un diviseur de tension formé par une première résistance R31 montée en parallèle entre la borne grille G du transistor de commutation Q3 et la masse M d'une part, et une deuxième résistance R32 montée en série entre la borne grille G du transistor commutation Q3 et l'interrupteur I. L'interrupteur I est monté en série avec une résistance de polarisation R3.

Ainsi, lorsque l'interrupteur I est configuré dans sa position fermée, alors un court-circuit est établi entre les premières et deuxièmes résistances R31, R32. Le transistor de commutation Q3 est polarisé par un pont diviseur formée par la première résistance R31 et la résistance de polarisation R3. Ces deux résistances forment collectivement un état de polarisation qui configure le transistor de polarisation Q3 dans un état bloqué. Le transistor de polarisation Q3 se comporte ainsi comme un interrupteur ouvert, rendant le circuit de décharge 100 inactif car la résistance de décharge R5 n'est plus reliée à la masse M du système électrique haute tension 10.

En revanche, lorsque l'interrupteur I est configuré dans sa position ouverte, alors le transistor de commutation Q3 est polarisé par un pont diviseur formée par la première résistance R31 et la deuxième résistance R32. Ces deux résistances forment collectivement un état de polarisation qui configure le transistor de polarisation Q3 dans un état de conduction. La résistance de décharge R5 est électriquement connectée à la masse M du système électrique haute tension 10, et le circuit de décharge 100 est actif, permettant ainsi de décharger le condensateur 400 via le premier transistor de puissance Q1.

Comme décrit précédemment, l'interrupteur I peut avantageusement être piloté par une commande extérieure, du type « interlock » par exemple.

L'interrupteur I est protégé des surtensions par une diode de protection D3 et une capacité de filtrage C3 montées en parallèle de l'interrupteur et de la résistance de polarisation R3.

Enfin, la branche de pilotage 120 du premier transistor de puissance Q1 comprend une résistance de polarisation R6 du premier transistor de puissance Q1, la branche de régulation 130 étant connectée entre la résistance de polarisation R6 et la borne grille G du premier transistor de puissance Q1. La branche de pilotage 120 du premier transistor de puissance Q1 comprend aussi une diode de protection D6 agencée pour protéger la branche de dissipation et le premier transistor de puissance Q1, en bloquant un courant circulant dans le sens opposé à celui imposé par la diode et/ou en protégeant la branche de pilotage contre d'éventuelles surtensions.

Bien sûr, l'invention n'est pas limitée aux exemples qui viennent d'être décrits et de nombreux aménagements peuvent être apportés à ces exemples sans sortir du cadre de l'invention comme définie dans les revendications.

## Revendications

1. Circuit de décharge (100) d'un système électrique haute tension (10) comprenant au moins un transistor de puissance (Q1) et un dispositif de stockage d'énergie électrique (400) comprenant au moins un condensateur (C3), le circuit de décharge (100) comprenant:
- une branche de pilotage (120) étant reliée à une borne grille du transistor de puissance (Ql), la branche de pilotage (120) permettant de configurer le transistor de puissance (Ql) dans un mode de conduction afin de décharger le condensateur (C3), le transistor de puissance (Ql) formant une branche de dissipation ;
- une branche de régulation (130) agencée pour contrôler un courant de grille (iG) entrant dans la branche de pilotage (120) du transistor de puissance (Ql) ;
**caractérisé en ce que** la branche de régulation (130) est agencée pour commander le courant de grille (iG) de manière à ce que chaque transistor de puissance (Ql) dissipe une puissance inférieure ou égale à 5W pendant une durée de décharge inférieure ou égale à 5 secondes permettant de décharger le condensateur (C3), et **en ce que** la branche de régulation (130) est montée en dérivation d'une borne émettrice (E) du transistor de puissance (Ql) de la branche de dissipation, et **en ce que** la branche de régulation (130) comprend un transistor de régulation (Q4) polarisé en dérivation de la borne émettrice (E) du transistor de puissance (Q1) de la branche de dissipation, une borne collectrice (C) du transistor de régulation (Q4) étant reliée à la branche de pilotage (120) de la branche de dissipation et **en ce que** le transistor de régulation (Q4) est polarisé d'une part via une résistance (R4) montée en dérivation entre une borne grille (G) et une borne émettrice (E) du transistor de régulation (Q4), et d'autre part via une capacité de filtrage (C4) montée entre la borne émettrice du transistor de puissance (Ql) et la borne grille du transistor de régulation (Q4).

2. Circuit de décharge (100) selon la revendication précédente, **caractérisé en ce que** la branche de régulation (130) comprend une résistance de décharge (R5) montée en dérivation entre la borne grille (G) et la borne émettrice (E) du transistor de régulation (Q4).

3. Circuit de décharge (100) selon l'une quelconque des revendications précédentes, **caractérisé en ce que** la branche de régulation (130) est agencée pour que le courant de grille (iG) entrant dans la branche de dissipation soit constant.

4. Circuit de décharge (100) selon l'une quelconque des revendications précédentes, **caractérisé en ce que** la branche de régulation (130) est agencée pour que le courant de grille (iG) entrant dans la branche de dissipation varie linéairement.

5. Circuit de décharge (100) selon l'une quelconque des revendications précédentes, **caractérisé en ce que** la branche de pilotage (120) de la branche de dissipation comprend une résistance de polarisation (R6) du transistor de puissance (QI), la branche de régulation (130) étant connectée entre la résistance de polarisation (R6) et la borne grille (G) du transistor de puissance (QI).

6. Circuit de décharge (100) selon l'une quelconque des revendications précédentes, **caractérisé en ce que** la branche de pilotage (120) de la branche de dissipation comprend une diode de protection (D6) agencée pour protéger la branche de dissipation.

7. Circuit de décharge (100) selon l'une quelconque des revendications précédentes, **caractérisé en ce que** la branche de commutation (110) comprend :
- un transistor de commutation (Q3) monté en série entre la branche de régulation (130) et un point de potentiel électrique bas (M) du circuit de décharge (100) via respectivement une borne collectrice (C) et une borne émettrice (E);
- un interrupteur (1) monté en dérivation d'une branche de polarisation (102) du transistor de commutation (Q3) entre une borne grille (G) et la borne émettrice (E) du transistor de commutation (Q3),
la branche de polarisation (102) du transistor de commutation (Q3) comprenant un diviseur de tension formé par :
- une première résistance (R31) montée en parallèle entre la borne grille (G) du transistor de commutation (Q3) et le point de potentiel électrique bas (M) du circuit de décharge (100) ;
- une deuxième résistance (R32) montée en série entre la borne grille (G) du transistor de commutation (Q3) et l'interrupteur (1).

8. Circuit de décharge (100) selon l'une quelconque des revendications précédentes, **caractérisé en ce que** l'interrupteur (1) est piloté par un signal électrique de commande pouvant prendre au moins une première valeur et une deuxième valeur, l'interrupteur (1) pouvant être configuré :
- dans la première position pour la première valeur du signal électrique de commande ; et
- dans la deuxième position pour la deuxième valeur du signal électrique de commande.

9. Utilisation d'un circuit de décharge (100) selon l'une quelconque des revendications précédentes pour décharger un convertisseur DC/DC ou un chargeur électrique.

10. Utilisation d'un circuit de décharge (100) selon l'une quelconque des revendications 1 à 8 pour décharger un compresseur électrique de véhicule automobile.

11. Unité de contrôle d'une machine électrique de puissance (300), l'unité de contrôle comprenant un circuit de décharge (100) selon l'une quelconque des revendications 1 à 8, **caractérisé en ce que** le transistor de puissance (QI) est du type d'un transistor bipolaire à grille isolée, et **en ce que** la branche de dissipation comprend au moins un demi-pont de puissance, chaque demi-pont comprenant le premier (QI) et un deuxième (Q2) transistor de puissance, les premier et deuxième transistors de puissance (Q1, Q2) étant montés en série par un point de potentiel commun reliant la borne émettrice (E) du premier transistor de puissance (QI) à une borne collectrice (C) du deuxième transistor de puissance (Q2) .

12. Unité de contrôle selon la revendication précédente, **caractérisé en ce que** chaque premier et deuxième transistor de puissance (QI, Q2) comprend une branche de polarisation montée en dérivation entre sa borne grille (G) et sa borne émettrice (E).

13. Unité de contrôle selon la revendication précédente, **caractérisé en ce que** la branche de polarisation de chaque transistor de puissance (QI, Q2) comprend une résistance de polarisation (RI, R2) et une capacité de filtrage (Cl, C2).

## Patentansprüche

1. Entladeschaltung (100) eines elektrischen Hochspannungssystems (10), das mindestens einen Leistungstransistor (Q1) und eine Speichervorrichtung elektrischer Energie (400) enthält, die mindestens einen Kondensator (C3) enthält, wobei die Entladeschaltung (100) enthält:
- einen mit einem Gateanschluss des Leistungstransistors (Q1) verbundenen Steuerzweig (120), wobei der Steuerzweig (120) es ermöglicht, den Leistungstransistor (Q1) in einem Leitungsmodus zu konfigurieren, um den Kondensator (C3) zu entladen, wobei der Leistungstransistor (Q1) einen Ableitungszweig bildet;
- einen Regelungszweig (130), der eingerichtet ist, um einen Gatestrom (iG) zu kontrollieren, der in den Steuerzweig (120) des Leistungstransistors (Q1) eintritt;
**dadurch gekennzeichnet, dass** der Regelungszweig (130) eingerichtet ist, um den Gatestrom (iG) so zu steuern, dass jeder Leistungstransistor (Q1) eine Leistung von weniger als oder gleich 5W während einer Entladedauer von weniger als oder gleich 5 Sekunden ableitet, was es ermöglicht, den Kondensator (C3) zu entladen, und dass der Regelungszweig (130) in Abzweigung eines Emitteranschlusses (E) des Leistungstransistors (Q1) des Ableitungszweigs montiert ist, und dass der Regelungszweig (130) einen Regelungstransistor (Q4) enthält, der in Abzweigung des Emitteranschlusses (E) des Leistungstransistors (Q1) des Ableitungszweigs montiert ist, wobei ein Sammelanschluss (C) des Regelungstransistors (Q4) mit dem Steuerzweig (120) des Ableitungszweigs verbunden ist, und dass der Regelungstransistor (Q4) einerseits über einen Widerstand (R4), der in Abzweigung zwischen einem Gateanschluss (G) und einem Emitteranschluss (E) des Regelungstransistors (Q4) montiert ist, und andererseits über einen Filterkondensator (C4) polarisiert ist, der zwischen dem Emitteranschluss des Leistungstransistors (Q1) und dem Gateanschluss des Regelungstransistors (Q4) montiert ist.

2. Entladeschaltung (100) nach dem vorhergehenden Anspruch, **dadurch gekennzeichnet, dass** der Regelungszweig (130) einen Entladewiderstand (R5) enthält, der in Abzweigung zwischen dem Gateanschluss (G) und dem Emitteranschluss (E) des Regelungstransistors (Q4) montiert ist.

3. Entladeschaltung (100) nach einem der vorhergehenden Ansprüche, **dadurch gekennzeichnet, dass** der Regelungszweig (130) eingerichtet ist, damit der in den Ableitungszweig eintretende Gatestrom (iG) konstant ist.

4. Entladeschaltung (100) nach einem der vorhergehenden Ansprüche, **dadurch gekennzeichnet, dass** der Regelungszweig (130) eingerichtet ist, damit der in den Ableitungszweig eintretende Gatestrom (iG) linear variiert.

5. Entladeschaltung (100) nach einem der vorhergehenden Ansprüche, **dadurch gekennzeichnet, dass** der Steuerzweig (120) des Ableitungszweigs einen Polarisationswiderstand (R6) des Leistungstransistors (Q1) enthält, wobei der Regelungszweig (130) zwischen dem Polarisationswiderstand (R6) und dem Gateanschluss (G) des Leistungstransistors (Q1) verbunden ist.

6. Entladeschaltung (100) nach einem der vorhergehenden Ansprüche, **dadurch gekennzeichnet, dass** der Steuerzweig (120) des Ableitungszweigs eine Schutzdiode (D6) enthält, die eingerichtet ist, um den Ableitungszweig zu schützen.

7. Entladeschaltung (100) nach einem der vorhergehenden Ansprüche, **dadurch gekennzeichnet, dass** der Schaltzweig (110) enthält:
- einen Schalttransistor (Q3), der zwischen dem Regelungszweig (130) und einem Punkt niedrigen elektrischen Potentials (M) der Entladeschaltung (100) über einen Sammelanschluss (C) bzw. einen Emitteranschluss (E) in Reihe geschaltet ist,
- einen Schalter (1), der in Abzweigung eines Polarisationszweigs (102) des Schalttransistors (Q3) zwischen einem Gateanschluss (G) und dem Emitteranschluss (E) des Schalttransistors (Q3) montiert ist,
wobei der Polarisationszweig (102) des Schalttransistors (Q3) einen Spannungsteiler enthält, der gebildet wird von:
- einem ersten Widerstand (R31), der zwischen dem Gateanschluss (G) des Schalttransistors (Q3) und dem Punkt niedrigen elektrischen Potentials (M) der Entladeschaltung (100) parallelgeschaltet ist;
- einem zweiten Widerstand (R32), der zwischen dem Gateanschluss (G) des Schalttransistors (Q3) und dem Schalter (1) in Reihe geschaltet ist.

8. Entladeschaltung (100) nach einem der vorhergehenden Ansprüche, **dadurch gekennzeichnet, dass** Schalter (1) von einem elektrischen Steuersignal gesteuert wird, das mindestens einen ersten Wert und einen zweiten Wert annehmen kann, wobei der Schalter (1) konfiguriert sein kann:
- in der ersten Stellung für den ersten Wert des elektrischen Steuersignals; und
- in der zweiten Stellung für den zweiten Wert des elektrischen Steuersignals.

9. Verwendung einer Entladeschaltung (100) nach einem der vorhergehenden Ansprüche zum Entladen eines DC/DC-Wandlers oder eines elektrischen Ladegeräts.

10. Verwendung einer Entladeschaltung (100) nach einem der Ansprüche 1 bis 8 zum Entladen eines elektrischen Verdichters eines Kraftfahrzeugs.

11. Kontrolleinheit einer elektrischen Leistungsmaschine (300), wobei die Kontrolleinheit eine Entladeschaltung (100) nach einem der Ansprüche 1 bis 8 enthält, **dadurch gekennzeichnet, dass** der Leistungstransistor (Q1) vom Typ eines Bipolartransistors mit isoliertem Gate ist, und dass der Ableitungszweig mindestens eine Leistungshalbbrücke enthält, wobei jede Halbbrücke den ersten (Q1) und einen zweiten (Q2) Leistungstransistor enthält,
wobei der erste und der zweite Leistungstransistor (Q1, Q2) durch einen gemeinsamen Potentialpunkt in Reihe geschaltet sind, der den Emitteranschluss (E) des ersten Leistungstransistors (Q1) mit einem Sammelanschluss (C) des zweiten Leistungstransistors (Q2) verbindet.

12. Kontrolleinheit nach dem vorhergehenden Anspruch, **dadurch gekennzeichnet, dass** jeder erste und zweite Leistungstransistor (Q1, Q2) einen Polarisationszweig enthält, der in Abzweigung zwischen seinen Gateanschluss (G) und seinen Emitteranschluss (E) montiert ist.

13. Kontrolleinheit nach dem vorhergehenden Anspruch, **dadurch gekennzeichnet, dass** der Polarisationszweig jedes Leistungstransistors (Q1, Q2) einen Polarisationswiderstand (R1, R2) und einen Filterkondensator (C1, C2) enthält.

## Claims

1. Circuit (100) for discharging a high-voltage electrical system (10) comprising at least one power transistor (Q1) and a device (400) for storing electrical energy comprising at least one capacitor (C3), the discharging circuit (100) comprising:
- a driving branch (120) that is connected to a gate terminal of the power transistor (Q1), the driving branch (120) allowing the power transistor (Q1) to be configured into a conduction mode in order to discharge the capacitor (C3), the power transistor (Q1) forming a dissipating branch;
- a regulating branch (130) arranged to control a gate current (iG) entering into the branch (120) for driving the power transistor (Q1);
**characterized in that** the regulating branch (130) is arranged to control the gate current (iG) such that each power transistor (Q1) dissipates a power lower than or equal to 5 W during a discharging time shorter than or equal to 5 seconds allowing the capacitor (C3) to be discharged, and **in that** the regulating branch (130) is connected in parallel with an emitter terminal (E) of the power transistor (Q1) of the dissipating branch, and **in that** the regulating branch (130) comprises a regulating transistor (Q4) biased in parallel with the emitter terminal (E) of the power transistor (Q1) of the dissipating branch, a collector terminal (C) of the regulating transistor (Q4) being connected to the branch (120) for driving the dissipating branch and **in that** the regulating transistor (Q4) is biased on the one hand via a resistor (R4) connected in parallel between a gate terminal (G) and an emitter terminal (E) of the regulating transistor (Q4), and on the other hand via a filtering capacitor (C4) connected between the emitter terminal of the power transistor (Q1) and the gate terminal of the regulating transistor (Q4).

2. Discharging circuit (100) according to the preceding claim, **characterized in that** the regulating branch (130) comprises a discharging resistor (R5) connected in parallel between the gate terminal (G) and the emitter terminal (E) of the regulating transistor (Q4).

3. Discharging circuit (100) according to either one of the preceding claims, **characterized in that** the regulating branch (130) is arranged such that the gate current (iG) entering into the dissipating branch is constant.

4. Discharging circuit (100) according to any one of the preceding claims, **characterized in that** the regulating branch (130) is arranged such that the gate current (iG) entering into the dissipating branch varies linearly.

5. Discharging circuit (100) according to any one of the preceding claims, **characterized in that** the branch (120) for driving the dissipating branch comprises a resistor (R6) for biasing the power transistor (Q1), the regulating branch (130) being connected between the biasing resistor (R6) and the gate terminal (G) of the power transistor (Q1).

6. Discharging circuit (100) according to any one of the preceding claims, **characterized in that** the branch (120) for driving the dissipating branch comprises a protecting diode (D6) arranged to protect the dissipating branch.

7. Discharging circuit (100) according to any one of the preceding claims, **characterized in that** the switching branch (110) comprises:
- a switching transistor (Q3) connected in series between the regulating branch (130) and a point (M) of low electrical potential of the discharging circuit (100) via a collector terminal (C) and an emitter terminal (E), respectively;
- a switch (1) connected in parallel with a branch (102) for biasing the switching transistor (Q3) between a gate terminal (G) and the emitter terminal (E) of the switching transistor (Q3),
the branch (102) for biasing the switching transistor (Q3) comprising a voltage divider formed by:
- a first resistor (R31) connected in parallel between the gate terminal (G) of the switching transistor (Q3) and the point (M) of low electrical potential of the discharging circuit (100);
- a second resistor (R32) connected in series between the gate terminal (G) of the switching transistor (Q3) and the switch (1).

8. Discharging circuit (100) according to any one of the preceding claims, **characterized in that** the switch (1) is driven by an electrical command signal able to take at least a first value and a second value, the switch (1) being able to be configured:
- into the first position for the first value of the electrical command signal; and
- into the second position for the second value of the electrical command signal.

9. Use of a discharging circuit (100) according to any one of the preceding claims to discharge a DC/DC converter or an electrical charger.

10. Use of a discharging circuit (100) according to any one of Claims 1 to 8 to discharge an electric motor-vehicle compressor.

11. Unit for controlling a power electrical machine (300), the control unit comprising a discharging circuit (100) according to any one of Claims 1 to 8, **characterized in that** the power transistor (Q1) is an insulated-gate bipolar transistor, and **in that** the dissipating branch comprises at least one power half-bridge, each half-bridge comprising the first (Q1) and a second (Q2) power transistor, the first and second power transistors (Q1, Q2) being connected in series by a point of common potential linking the emitter terminal (E) of the first power transistor (Q1) to a collector terminal (C) of the second power transistor (Q2).

12. Control unit according to the preceding claim, **characterized in that** each first and second power transistor (Q1, Q2) comprises a biasing branch connected in parallel between its gate terminal (G) and its emitter terminal (E).

13. Control unit according to the preceding claim, **characterized in that** the biasing branch of each power transistor (Q1, Q2) comprises a biasing resistor (R1, R2) and a filtering capacitor (C1, C2).
